# EUROPEAN PATENT SPECIFICATION

(11) **EP 2 958 230 B1**
(45) Date of publication and mention of the grant of the patent: **08.04.2020**
(21) Application number: 14751810.4
(22) Date of filing: 15.02.2014
(51) Int. Cl.: H02S 20/10

(54) **SOLAR CELL DEVICE**
SOLARZELLENVORRICHTUNG
DISPOSITIF DE CELLULES SOLAIRES

(30) Priority: 18.02.2013 JP 2013029145; 26.12.2013 JP 2013269079
(43) Date of publication of application: 23.12.2015
(73) Proprietor: KYOCERA Corporation, Kyoto 612-8501 (JP)
(72) Inventor: FUJIKAWA, Yoshiyuki, Kyoto-shi Kyoto 612-8501 (JP); NISHIKAWA, Kazuhide, Kyoto-shi Kyoto 612-8501 (JP); KITANO, Takahiro, Kyoto-shi Kyoto 612-8501 (JP)
(74) Representative: Viering, Jentschura & Partner mbB Patent- und Rechtsanwälte
(86) International application number: PCT/JP2014/053565
(87) International publication number: WO 2014/126226

(56) References cited:
- WO-A1-2012/165538
- DE-U1-202009 005 576
- DE-U1-202010 012 826
- JP-A- 2007 270 529
- JP-A- 2012 002 044
- JP-A- 2012 002 044
- US-S1- D 672 472

## Description

### TECHNICAL FIELD

The present invention relates to a solar cell device according to the preamble of claim 1.

### BACKGROUND

Solar cell devices are provided with solar cell modules performing photoelectric conversion, support members for fixing the solar cell modules, and the like. A solar cell device of the aforementioned type is known from JP 2007 270529 A, for example.

In particular, large scale photovoltaic generation facilities (mega solar) producing more than about 1 megawatt have been built by installing a large number of solar cell devices. There is a demand for mega solar power plant to be constructed at low cost and high quality within a predetermined period of time.

The base used as the foundations of the solar cell device is installed by placing concrete onsite. In addition, as the base, precast concrete manufactured in a factory may be installed at a predetermined position.

For the method of placing concrete on site, a long time is necessary to install the formwork and cure the concrete. In addition, with precast concrete, a long time is necessary for the transportation of the base, the installation work, and the like. In this manner, since the installation of the base takes a long time, the construction period and the cost of the base take up a high proportion of the entire construction work.

Thus, Japanese Utility Model Registration No. 3165884 proposes a solar cell device aiming to reduce costs by devising a base structure.

### SUMMARY OF THE INVENTION

### Problems to be Solved by the Invention

Since the method disclosed in Japanese Utility Model Registration No. 3165884 employs a structure supporting a large number of solar cell modules on one base, a large scale base is necessary. Therefore, the installation of the base takes a long time.

An object of the present invention is to provide a solar cell device with a reduced number of components and with excellent workability.

### Means to Solve the Problem

The present invention provides a solar cell device according to claim 1. Further advantageous embodiments of the present invention are disclosed in the dependent claims.

### EFFECT OF THE INVENTION

The solar cell device of the present embodiment supports the first solar cell array and the second solar cell array with a common support member. This reduces the number of the support members and bases. In the present embodiment, the base for the support member can be constructed on a smaller scale. As a result, the workability is improved since it is possible to shorten the installation time of the support member and foundations for the solar cell device.

### BRIEF DESCRIPTION OF THE DRAWINGS

FIG. 1 is a perspective view illustrating an embodiment of a solar cell device of the present invention.
FIGS. 2A and 2B are diagrams illustrating an example of a solar cell module forming one embodiment of the present invention, FIG. 2A is a plan view where the solar cell module is seen from a light receiving surface side, and FIG. 2B is a cross-sectional view taken along line A-A' in FIG. 2A.
FIGS. 3A and 3B are diagrams illustrating one embodiment of the present invention, FIG. 3A is an exploded perspective view illustrating an enlarged B section in FIG. 1, and FIG. 3B is a cross-section taken along line C-C' in FIG. 1.
FIGS. 4A and 4B are diagrams illustrating one embodiment of the present invention, FIG. 4A is an exploded perspective view illustrating an enlarged D section in FIG. 1, and FIG. 4B is a side surface view in the D section in FIG. 1.
FIG. 5 is a diagram illustrating one embodiment of the present invention and is an exploded perspective view illustrating an enlarged E section in FIG. 1.
FIG. 6 is a diagram illustrating another embodiment of the solar cell device of the present invention and is a side surface view illustrating a modification in the D section in FIG. 1.
FIG. 7 is a diagram illustrating another embodiment of the present invention and is an enlarged exploded perspective view illustrating a modification in the D section in FIG. 1.
FIG. 8 is a perspective view illustrating another embodiment of the present invention.
FIGS. 9A and 9B are diagrams illustrating another embodiment of the present invention, FIG. 9A is a side surface view illustrating a modification in the D section in FIG. 1, and FIG. 9B is a cross-sectional view illustrating a cross-section taken along F-F' in FIG. 9A.
FIGS. 10A and 10B are diagrams illustrating another embodiment of the present invention, FIG. 10A is an exploded perspective view corresponding to FIG. 3A, and FIG. 10B is a cross-sectional view illustrating a state after assembly in FIG. 10A.
FIG. 11 is a diagram illustrating another embodiment of the present invention and is an exploded perspective view corresponding to FIG. 3A.
FIGS. 12A and B are diagrams illustrating another embodiment of the present invention, FIG. 12A is an exploded perspective view corresponding to FIG. 3A, and FIG. 12B is a perspective view illustrating a state where a traverse rail member is seen from the rear side.

### BEST MODE FOR CARRYING OUT THE INVENTION

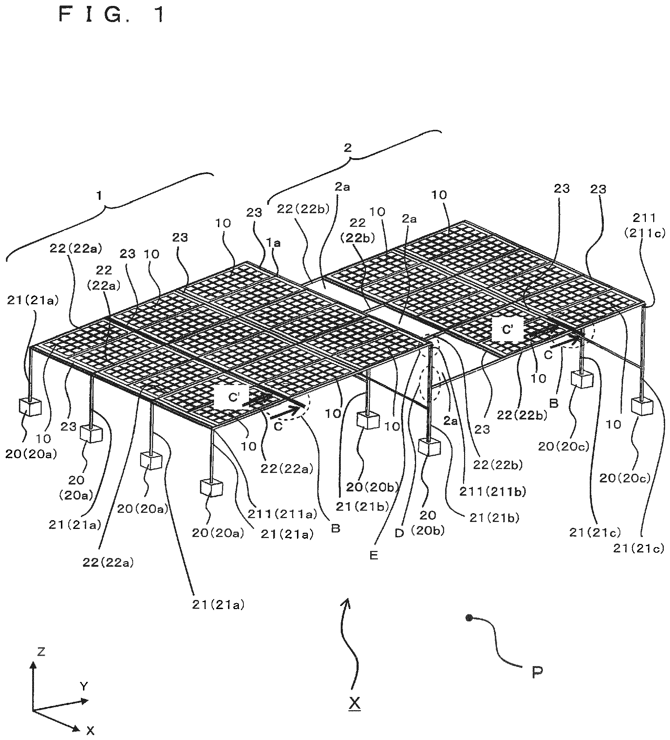

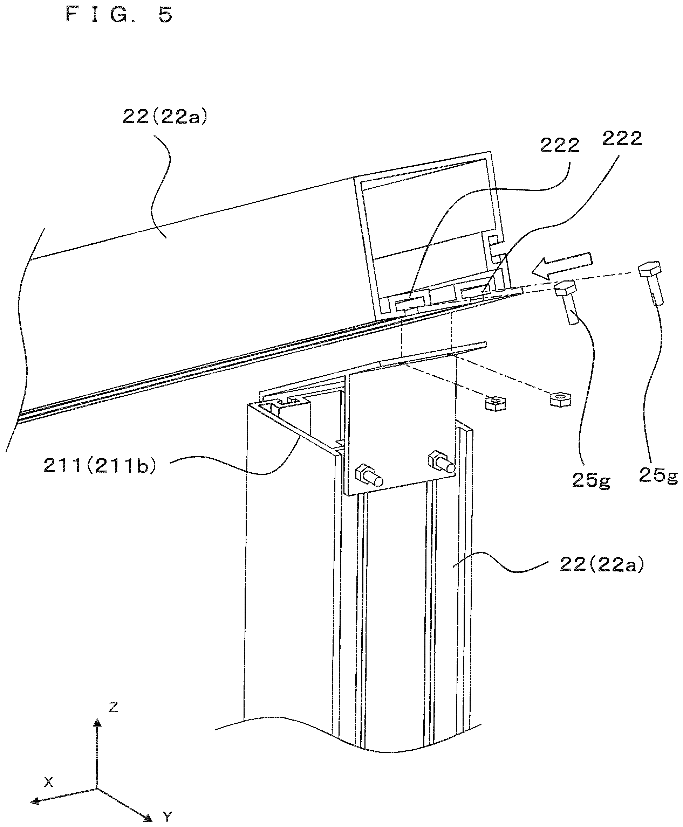

Description will be given of embodiments of the solar cell device of the present invention with reference to the drawings. Here, in FIG. 1 and FIGS. 3A to 12B, a direction parallel to light receiving surfaces of solar cell modules 10 forming a solar cell device X according to an embodiment of the present invention and orthogonal to an inclined direction in which the light receiving surface is inclined with respect to an installation surface is set as the X axis direction. In addition, in the present embodiment, a direction along which a first solar cell array 1 and a second solar cell array 2 are side by side and parallel to the ground is set as the Y axis direction. In addition, in the present embodiment, a direction orthogonal to the ground (installation surface) is set as the Z axis direction. In addition, in the following description, in FIG. 1 and the like, the lower side (-Y direction side) of the solar cell array of the solar cell device X in the inclined direction may be referred to as the eaves side and the upper side (+Y direction side) in the inclined direction may be referred to as the ridge side.

### (First Embodiment)

As illustrated in FIG. 1, the solar cell device X according to the present embodiment is provided with the first solar cell array 1 and the second solar cell array 2 installed side by side in the Y axis direction on ground P. In addition, the solar cell device X is provided with a plurality of bases 20 and a plurality of support members 21. Here, in the following description, the bases 20 positioned on the eaves side of the first solar cell array 1 are set as first bases 20a. In addition, the bases 20 positioned on the ridge side of the first solar cell array 1 and the eaves side of the second solar cell array 2 are set as second bases 20b. In addition, the bases 20 positioned on the ridge side of the second solar cell array 2 are set as third bases 20c. In addition, the support members 21 disposed on the eaves side of the first solar cell array 1 are first support members 21a, the support members 21 disposed on the ridge side of the first solar cell array 1 are second support members 21b, and the support members 21 disposed on the ridge side of the second solar cell array 2 are third support members 21c. Furthermore, the holding members 22 used in the first solar cell array 1 are first holding members 22a and the holding members 22 used in the second solar cell array 2 are second holding members 22b.

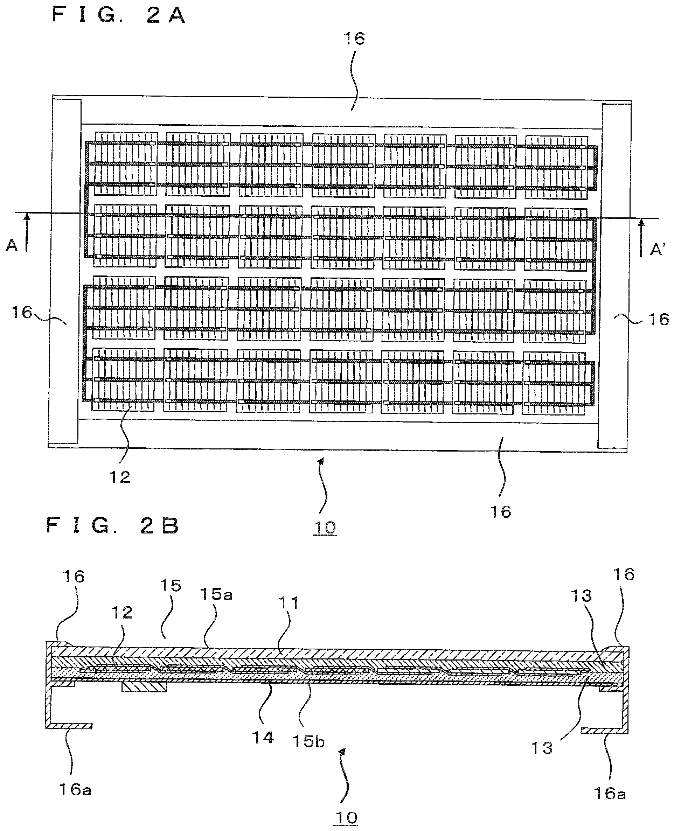

Next, detailed description will be given of each member forming the solar cell device X illustrated in FIG. 1 and FIGS. 2A and 2B.

### <First Solar Cell Array>

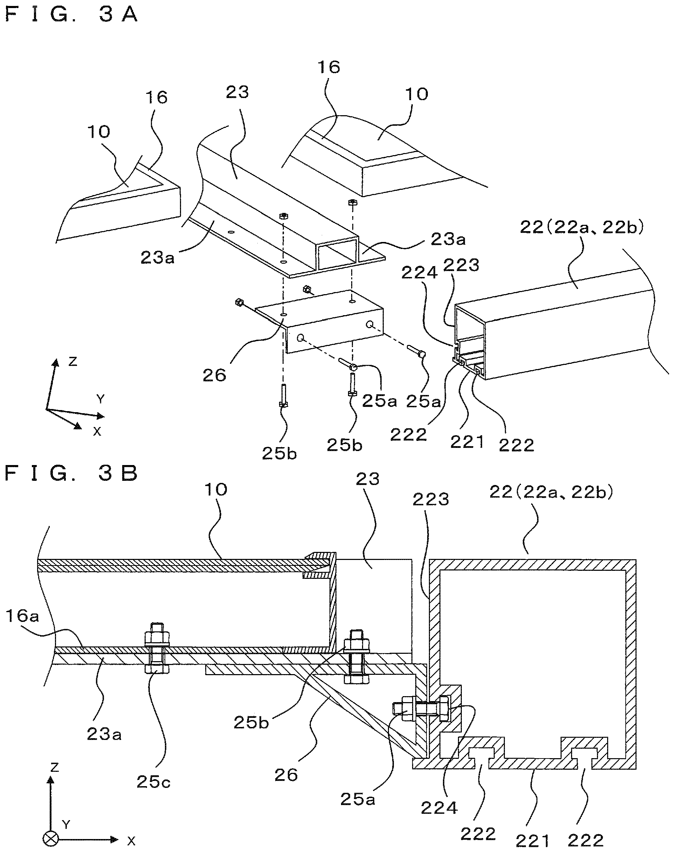

As illustrated in FIG. 1 and FIGS. 3A and 3B, the first solar cell array 1 has the solar cell modules 10 and a member supporting the solar cell modules 10. Next, description will be given of the members forming the first solar cell array 1 in order from the lower side (-Z direction side) thereof. The first solar cell array 1 is supported by the first bases 20a and the second bases 20b disposed on the ground P, which corresponds to the installation surface. As illustrated in FIG. 1, a plurality of the first bases 20a is disposed at regular intervals along the X axis direction. In addition, the second bases 20b are disposed at regular gaps from each of the first bases 20a in the +Y direction.

In addition, the support members 21 are respectively provided on the first bases 20a and the second bases 20b. In more detail, the columnar first support members 21a are provided on the first bases 20a and the columnar second support members 21b are provided on the second bases 20b. At this time, the first support members 21a are formed to be shorter than the second support members 21b. Then, as illustrated in FIG. 1, on each of first top portions 211a of the first support members 21a and second top portions 211b of the second support members 21b, the first holding members 22a are provided at an incline according to the number of the solar cell modules 10 to be installed.

In addition, traverse rail members 23 are provided so as to straddle the plurality of first holding members 22a installed to be substantially parallel to each other in the X axis direction. A plurality of the traverse rail members 23 is provided with the X axis direction as the longitudinal direction. At this time, the longitudinal direction of the traverse rail members 23 is positioned to intersect with the longitudinal direction of the first holding members 22a. The traverse rail members 23 are provided at gaps in the longitudinal direction of the first holding members 22a, the gaps being substantially identical to the length of the solar cell modules 10 in the X axis direction. In addition, the plurality of traverse rail members 23 is installed so as to be parallel to each other. The first holding members 22a and the traverse rail members 23 are fixed by, for example, connecting members 26 on inner wall surfaces 223 of the first holding members 22a using first fastening members 25a as illustrated in FIGS. 3A and 3B. In addition, the sides of the traverse rail members 23 are fixed on the connecting members 26 using second fastening members 25b. In addition, a bottom portion 16a of a frame 16 which is an outer peripheral section of the solar cell module 10 is mounted and held on protruding portion 23a of the traverse rail member 23 on the first holding member 22a. The frame 16 and the traverse rail member 23 are fastened and fixed by a third fastening member 25c.

### <Second Solar Cell Array>

In the same manner as the first solar cell array 1, the second solar cell array 2 has the solar cell modules 10 and members supporting the solar cell modules 10. Next, description will be given of the members forming the second solar cell array 2 in order from the lower side (-Z direction side) thereof. The ridge side of the second solar cell array 2 is supported by the third bases 20c disposed on the ground P. As illustrated in FIG. 1, the third bases 20c are disposed at regular gaps from each of the second bases 20b in the +Y direction. In addition, the third support members 21c are provided on each of the third bases 20c.

In addition, as illustrated in FIG. 1, the second holding members 22b are provided along a direction inclined with respect to the ground P. Then, in the second solar cell array 2, parts of the second holding members 22b positioned on the upper side in the inclined direction are fixed on third top portions 211c of the third support members 21c. Furthermore, in the second solar cell array 2, parts of the second holding members 22b positioned on the lower side in the inclined direction are fixed on side portions 212 of the second support members 21b.

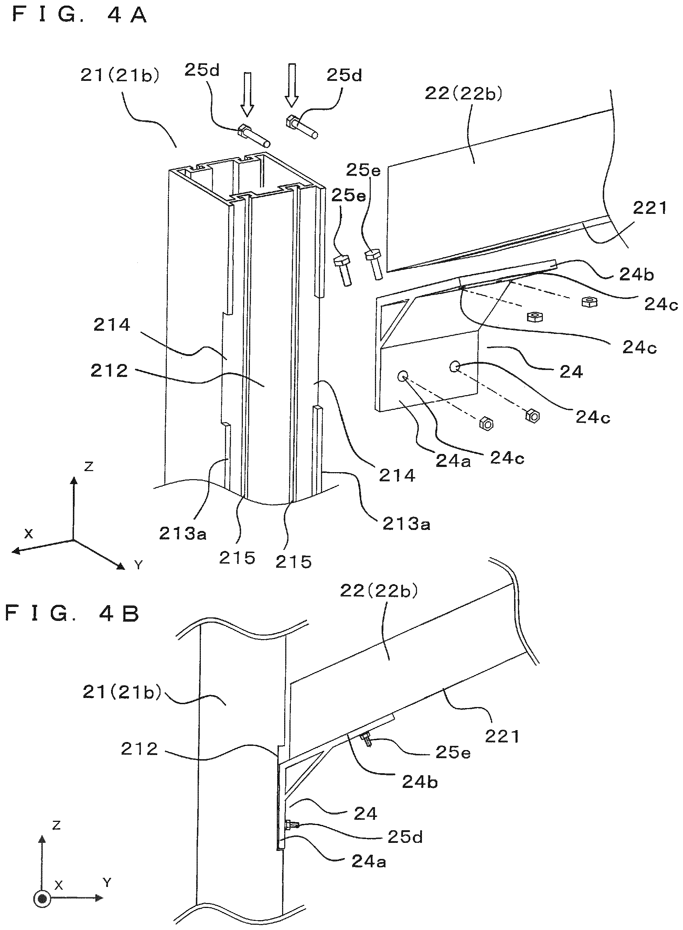

In more detail, as illustrated in FIGS. 4A and 4B, a site on the lower side of the second holding member 22b is fixed via an attachment member 24 to the side portion 212 of the second support member 21b of the first solar cell array 1 at a position from the third support member 21c in the -Y direction. The attachment portion 24 has a first attachment portion 24a along the side portion 212 of the second support member 21b and a second attachment portion 24b along a lower surface 221 of the second holding member 22b. Then, the second attachment portion 24b supports the second holding member 22b from below. In addition, the second support member 21b has a notched portion 214 with a width which is able to engage with the first attachment portion 24a of the attachment portion 24 on a flange portion 213a provided on the side portion 212. The first attachment portion 24a is fixed to the second support member 21b using a fourth fastening member 25d. In addition, the second attachment portion 24b is fixed to the second holding member 22b using a fifth fastening member 25e.

In addition, in the same manner as the first solar cell array 1, a plurality of the traverse rail members 23 is provided along the X axis direction between the plurality of second holding members 22b installed to be substantially parallel to each other in the Y axis direction. In the longitudinal direction of the second holding members 22b, a plurality of the traverse rail members 23 is provided at gaps substantially identical to the length of the solar cell modules 10 in the X axis direction.

As illustrated in FIGS. 3A and 3B, in the connection portion of the second holding member 22b and the traverse rail member 23, the connecting member 26 is fixed to the inner wall surface 223 of the second holding member 22b using the first fastening member 25a, and the traverse rail member 23 is fixed to the connecting member 26 using the second fastening member 25b. Then, the bottom portion 16a of the frame 16 which is the outer peripheral section of the solar cell module 10 is mounted and held on the protruding portion 23a of the traverse rail member 23 on the second holding member 22.

Here, as illustrated in FIG. 1, the second solar cell array 2 may have gap regions 2a where solar cell modules 10 are not provided between the second support members 21b and the solar cell modules 10 positioned on the lower side (the -Y direction side) in the inclined direction. The gap regions 2a indicate regions between a side of the second holding members 22 positioned on or above the second attachment portion 24b and the tops of the second holding members 22b holding the solar cell modules 10 positioned on the lower side (-Y direction side) in the inclined direction. By setting the gap regions 2a to a range wider than a region on which the shadow of an uppermost section 1a of the first solar cell array 1 falls at the time of the culmination of the winter solstice, it is possible to set the shadow of the first solar cell array 1 to not fall on the solar cell modules 10 of the second solar cell array 2. Due to this, the power generation efficiency of the solar cell array 2 is not easily decreased.

Next, detailed description will be given of constituent members of the solar cell device X.

### <Solar Cell Module>

As illustrated in FIGS. 2A and 2B, the solar cell module 10 is a collection of a plurality of solar cells 12 which is electrically connected with each other. For the solar cell module 10, it is possible to select from various structures such as, for example, a superstrate structure to which light is incident from the substrate side where the solar cells 12 are provided, a substrate structure to which light is incident from the opposite side to the substrate described above, or a double glass structure in which both surfaces of the solar cells 12 are surrounded by glass substrates and to which light is incident from both sides.

As illustrated in FIG. 2B, the solar cell module 10 has a translucent substrate 11, and a plurality of solar cells 12 disposed at predetermined positions with respect to the translucent substrate 11. In addition, the solar cell module 10 has a sealing material 13 for protecting the periphery of the plurality of solar cells 12, and a rear side protecting member 14. Then, the solar cell module 10 has a solar cell panel 15 in which the translucent substrate 11, the solar cells 12, the sealing material 13, and the rear side protecting member 14 are laminated. Here, the solar cell panel 15 has a first surface 15a (front surface) to which light is primarily incident, and a second surface 15b (rear surface) positioned on the rear side with respect to the first surface 15a.

The translucent substrate 11 has a function of protecting the solar cells 12 and the like from the first surface 15a side. Examples of the translucent substrate 11 include toughened glass, white glass, or the like.

The solar cells 12 have a function of converting incident light to electricity. The solar cells 12 have a semiconductor substrate formed from monocrystalline silicon, polycrystalline silicon, or the like, and electrodes provided on the surface (top surface) and the rear surface (lower surface) of the semiconductor substrate. The solar cells 12 having one of a monocrystalline silicon substrate and a polycrystalline silicon substrate have, for example, a rectangular shape in plan view. At this time, the size of one side of the solar cells 12 is, for example, from 100 to 200 mm. In the solar cells 12, for example, between the adjacent solar cells 12, the electrode positioned on the surface of one of the solar cells 12 and the electrode positioned on the rear surface of another of the solar cells 12 are electrically connected by a wiring material (inner lead). Due to this, the plurality of the solar cells 12 is arranged to be connected in series. Examples of the wiring material include copper foil coated with solder.

Here, the type of the solar cell 12 is not particularly limited. In addition to the above, for example, as the solar cell, one of a double-side light-receiving type solar cell which is able to photoelectrically convert light incident to both surfaces, and a thin film type solar cell where the photoelectric conversion portion in the solar cell element is formed from an amorphous silicon-based material, a chalcopyrite-based material such as CIGS, or a CdTe-based material may be employed.

The sealing material 13 provided on both main surface sides of the solar cells 12 has a function of sealing the solar cells 12. Examples of the sealing material 13 include thermosetting resins such as a copolymer of ethylene-vinyl acetate.

The rear side protecting member 14 has a function of protecting the solar cells 12 and the like from the second surface 15b side. The rear side protecting member 14 is adhered to the sealing material 13 positioned on the second surface 15b side of the solar cell panel 15. As the rear side protecting member 14, for example, it is possible to use polyvinyl fluoride (PVF), polyethylene terephthalate (PET), polyethylene naphthalate (PEN), or a member in which these are laminated as appropriate. In addition, in a case where the solar cell modules are double-side light-receiving solar cell modules, a translucent sealing material is used as the sealing material 13 positioned on the rear surface side of the solar cells 12. At this time, it is sufficient to use toughened glass, white glass, or the like as the rear side protecting member 14.

As illustrated in FIGS. 2A and 2B, the outer peripheral section of the solar cell modules 10 may be provided with the frame 16. The outer circumference of the solar cell panel 15 is protected in the frame 16. Due to this, it is possible to improve the resistance of the solar cell modules 10 with respect to loads. For the frame 16, for example, it is possible to use a frame formed from extrusion molding a metal such as an aluminum alloy.

### <Base>

The base 20 has a function as a platform for the solar cell device X. As the base 20, for example, it is possible to use a member which is a block of concrete embedded in the ground. At this time, in a case where the ground is soft, the contact pressure on the ground may be reduced by widening the width of the bottom portion of the base 20. When the base 20 is used, since the bottom portion of the base 20 is supported in the ground over a wide area, it is possible to reduce strain on the solar cell device X which accompanies unequal settling of the base 20. Due to this, damage or the like to the solar cell modules 10 is reduced. In addition, a long continuous footing may be used in addition to the rectangular base 20. Due to this, unequal settling is reduced since it is possible to further reduce the contact pressure on the ground.

Here, as the base 20, for example, a screw pile which is a kind of friction pile made of stainless steel may be used. The screw pile is a pile where spiral blades are provided on the outer circumference of a pile body with a circular cross-section and where the skin friction and pull-out resistance are improved. By using such a friction pile as the base 20, it is possible to increase the strength of the solar cell device X since the pull-out resistance is increased when pressure is applied to the solar cell device X by the wind blowing in a particular direction.

### <Support Member>

As illustrated in FIG. 1, the support members 21 include, for example, the first support member 21a disposed on the eaves side of the first solar cell array 1, the second support member 21b disposed on the ridge side of the first solar cell array 1, and the third support member 21c disposed on the ridge side of the second solar cell array 2.

The support member 21 is disposed on the base 20 such that the longitudinal direction is a direction (Z axis direction) substantially orthogonal to the ground P. In addition, the support members 21 are columnar bodies with an elongated shape extending along the Z axis direction. The support members 21 have top portions 211 which are the ends on the far side from the ground P. The holding members 22 are supported by the top portions 211 in the support members 21. In addition, the second support members 21b of the first solar cell array 1 have the side portions 212 which are the side surfaces of the side facing the second solar cell array 2.

As illustrated in FIGS. 4A and 4B, the cross-sectional shape of the support members 21 in a cross-section perpendicular to the longitudinal direction may be set to a square pipe shape in order to increase the strength. In addition, there are two flange portions 213a protruding from both sides of the side portion 212 of the support member 21 along the longitudinal direction of the support member 21 in the direction intersecting with the side portion 212. In addition, the support members 21 have a plurality of first recess portions 215 extending along the longitudinal direction of the support members 21 in the side portions 212. The flange portions 213a have the notched portions 214 able to engage with the first attachment portion 24a of the attachment portion 24 to be described below. In addition, the first recess portions 215 form recessed grooves having a greater width at a deeper part than at the opening part such that fixing is possible by inserting the bolt head of the fourth fastening member 25d. The width of the opening side of the first recess portion 215 is substantially the same as the diameter of the screw section of the bolt and the width of the deeper part is substantially the same as the width of the head of the bolt. It is possible to use the first recess portions 215 in order to fix the support members 21 and the attachment members 24. For the support members 21, for example, it is possible to use a member formed by extrusion molding a metal such as an aluminum alloy.

### <Holding Member>

As illustrated in FIG. 1, in the holding members 22, there are the first holding members 22a used in the first solar cell array 1 and the second holding members 22b used in the second solar cell array 2. Here, when the number of solar cell arrays is increased, the holding members 22 also increase in accordance with the amount of the increase. The first holding members 22a are members provided between the first top portions 211a of the first support members 21a and the second top portions 211b of the second support members 21b, and fixed so as to incline with respect to the ground P. The second holding members 22b are members which are fixed between the side portions 212 of the second support members 21b and the third top portions 211c of the third support members 21c so as to incline with respect to the ground P. As illustrated in FIGS. 3A and 3B, the cross-section shape of the holding members 22 may be set to a square pipe shape in order to increase the strength. Furthermore, a plurality of the second recess portions 222 is provided on the lower surfaces 221 of the holding members 22 along the longitudinal direction of the holding members 22 such that fixing is possible by inserting a bolt head. In addition, the holding members 22 have third recess portions 224 along the longitudinal direction of the inner wall surfaces 223. The first fastening members 25a fit into the second recess portions 222. Due to this, the support members 21 are fixed to the holding members 22. In addition, the fifth fastening members 25e are fitted into the third recess portions 224. Due to this, the support members 21 are fixed to the holding members 22 via the attachment members 24. For the holding members 22, for example, it is possible to use a member formed by extrusion molding a metal such as an aluminum alloy.

### <Traverse Rail Member>

As illustrated in FIG. 1 and FIGS. 3A and 4B, the traverse rail members 23 are disposed on the holding members 22 such that the longitudinal direction thereof is the X axis direction. As illustrated in FIGS. 3A and 3B, the traverse rail members 23 have the protruding portion 23a supporting the solar cell modules 10 and are able to fix the solar cell modules 10. For the traverse rail members 23, it is possible to use a member formed by extrusion molding a metal such as an aluminum alloy.

### <Attachment Member>

The attachment members 24 have a function of fixing the second holding members 22b of the second solar cell array 2 to the side portions 212 of the second support members 21b of the first solar cell array 1. As illustrated in FIGS. 4A and 4B, the attachment member 24 has the first attachment portion 24a attached by the fourth fastening member 25d to the side portion 212 of the second support member 21b. Furthermore, the attachment member 24 has the second attachment portion 24b joined with the first attachment portion 24a and supporting the second holding member 22b of the second solar cell array 2 from the ground P side. The second attachment portion 24b is fixed using the second recess portion 222 of the lower surface 221 of the second holding member 22b and the fifth fastening member 25e.

The first attachment portion 24a and the second attachment portion 24b have round holes 24c into which the fourth fastening member 25d and the fifth fastening member 25e are inserted.

### <Fastening Member>

The fastening members 25 include the first fastening member 25a, the second fastening member 25b, the third fastening member 25c, the fourth fastening member 25d, the fifth fastening member 25e, a sixth fastening member 25f, and a seventh fastening member 25g. The fastening members 25 may, for example, be members provided with a bolt and a nut. In addition, for the fastening members 25, it is possible to use a member made of a material such as stainless steel or iron.

As illustrated in FIG. 1, the solar cell device X according to the embodiment of the present invention includes a structure where the first holding member 22a of the first solar cell array 1 and the second holding member 22b of the second solar cell array 2 are supported by the second support member 21b. Due to this, since the first holding member 22a and the second holding member 22b are fixed by one support member (the second support member 21b) in the present embodiment, it is possible to reduce the number of support members 21 and the bases 20. As a result, it is possible to reduce the number of components.

In addition, in the construction work to install the bases 20, since the period of time for curing the concrete or lifting work takes up a large part of the construction period of the solar cell device X, the workability is improved by reducing the number of the bases 20. Therefore, in the present embodiment, it is possible to shorten the construction period for the installation of solar cell device X. Furthermore, when a columnar body provided to be orthogonal with respect to the ground P is selected for the second support members 21b, it is possible to reduce the area of the base 20 supporting the second support members 21b.

In addition, by the attachment members 24 engaging with the notched portions 214 of the second support members 21b, the work of positioning and attaching the attachment members 24 to the intermediate sections of the second support members 21b is easy. In addition, the workability is further improved since it is also possible to use the notched portions 214 for temporary fixing during the construction. For example, it is possible to make it less likely that the second holding member 22b will fall off, shift in position, or the like from the second support member 21b even when the fourth fastening member 25d is loosened after the construction of the second support member 21b and the second holding member 22b.

In addition, the attachment member 24 has the second attachment portion 24b supporting the second holding member 22b of the second solar cell array 2 from the ground P side. Due to this, while mounting the second holding member 22b on the second attachment portion 24b, it is possible to fasten the second attachment portion 24b and the second holding member 22b with the fifth fastening member 25e. Due to this, a worker does not need to carry out operations such as tightening with nuts and bolts while aligning the bolt holes by supporting the members in mid-air. As a result, the workability is improved.

### (Second Embodiment)

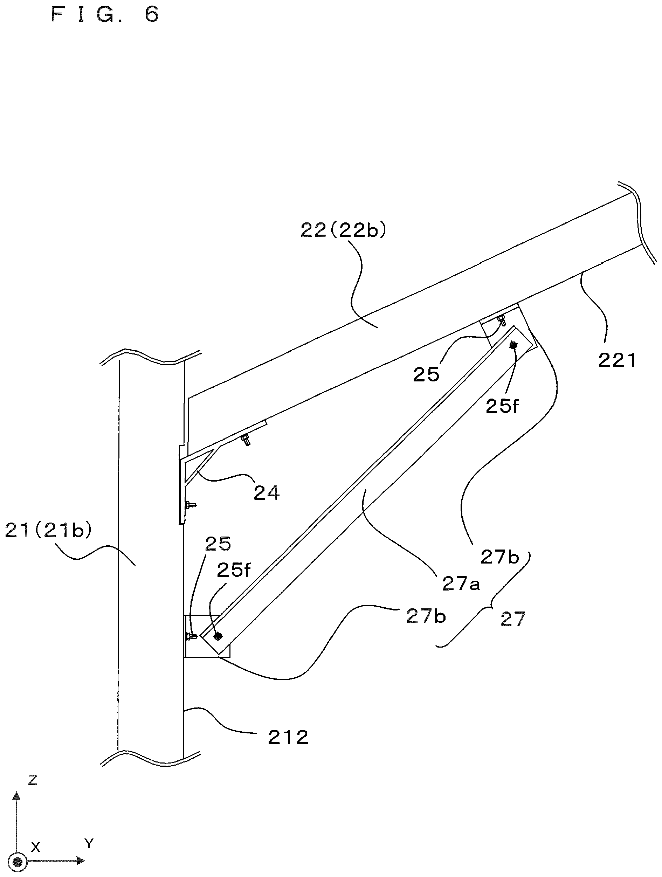

In the present embodiment, as illustrated in FIG. 6, a first reinforcing member 27 spanning from the lower surface of the second holding member 22b, which is positioned below the second holding member 22b in the inclined direction, to the second support member 21b is provided on the lower side of the attachment member 24. As illustrated in FIG. 6, in the first reinforcing member 27, one side of a rail member 27a is fixed to the lower surface 221 of the second holding member 22b via a fixing member 27b. In addition, in the first reinforcing member 27, the other side of the rail member 27a is fixed via the fixing member 27b to the side portion 212 of the second support member 21b closer to the ground P side than the position of the attachment member 24 attached to the second solar cell array 2.

It is possible to adjust and fix the position of the fixing member 27b using the first recess portion 215 of the second support member 21b and the second recess portion 222 of the second holding member 22.

The fixing member 27b is a member having a substantially T-shaped cross-sectional shape and has a plate shaped first surface which comes in contact with one of the second support member 21b and the second holding member 22b and a second surface which comes in contact with the rail member 27a. In addition, the first surface and the second surface have round holes into which it is possible to insert and fix the sixth fastening members 25f consisting of nuts and bolts.

By providing the first reinforcing member 27, it is possible to increase the strength of the second solar cell array 2 by supporting positive pressure loads applied to the second holding member 22b. Furthermore, it is possible to increase the strength with respect to loads applied to the second support member 21b in the Y axis direction (-Y direction).

### (Third Embodiment)

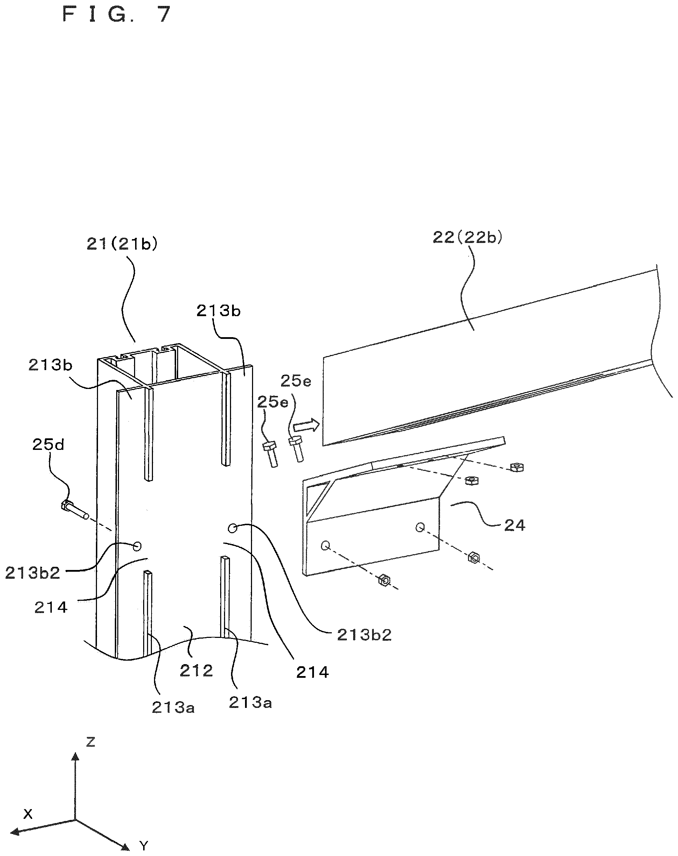

In the present embodiment, as illustrated in FIG. 7, the second support member 21b, which is a square pipe, is provided with the flange portions 213a and protruding portions 213b. As illustrated in FIG. 7, the flange portions 213a extend from the side portion 212 of the second support member 21b to the side of the second holding member 22b in the +Y direction. In addition, the protruding portions 213b respectively extend in the X axis direction from both ends of the side portion 212 of the second support member 21b. In addition, the flange portions 213a have the notched portions 214 engaging with the attachment member 24. In addition, the protruding portions 213b have round holes 213b2 into which the attachment member 24 and fastening member 25 are inserted for fastening.

When the second support member 21b has the shape described above, the workability is increased since it is possible to carry out the work while handling the nuts and bolts of the fastening members 25 from both sides when attaching the attachment member 24. Due to this, it is possible to further shorten the construction period for installing the solar cell device X by increasing the workability.

### (Fourth Embodiment)

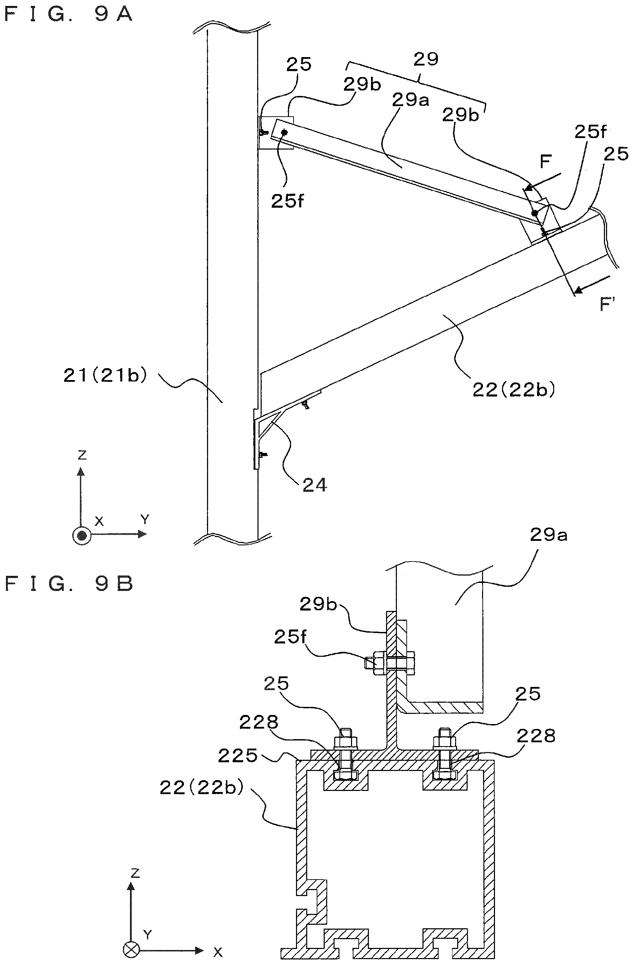

In the present embodiment, as illustrated in FIGS. 9A and 9B, a second reinforcing member 29 spanning from an upper surface of the second holding member 22b, which is positioned on the lower side of the second holding member 22b in the inclined direction, to the second support member 21b is provided above the attachment member 24. As illustrated in FIGS. 9A and 9B, in the second reinforcing member 29, one side of a rail member 29a is fixed to a top surface 225 of the second holding member 22b via a fixing member 29b. In addition, in the second reinforcing member 29, the other side of the rail member 29a is fixed via the fixing member 29b to the side portion 212 of the second support member 21b to be higher (side opposite to the ground P) than the position of the attachment member 24 attached to the second solar cell array 2. That is, the second reinforcing member 29 is fixed to the side portion 212 positioned between the site where the second holding member 22b and the second support member 21b are jointed, and the top portion of the second support member 21b.

It is possible for the fixing member 29b to adjust and fix the fastening position of the fastening member 25 using the first recess portion 215 of the second support member 21b and a fourth recess portion 228 provided on the top surface 225 of the second holding member 22.

By providing the second reinforcing member 29, in a case of using double-side light-receiving solar cell modules as the solar cell modules 10, it is possible to reduce the light shaded by the second reinforcing member 29 out of the sunlight diffused and reflected from the ground P side. Due to this, in the present embodiment, the strength of the solar cell device X is increased and it is possible to increase the amount of power generated by the solar cell device X by increasing the amount of light received on the rear surface sides of the solar cell modules 10.

In addition, the sunlight incident to the light receiving surface sides of the solar cell modules 10 is primarily directly reaching light incident in a line from the direction of the sun. Therefore, in the present embodiment, in consideration of the incident angle of the sunlight in the region where the solar cell device X is installed, the second reinforcing member 29 may be disposed such that the shadow of the second reinforcing member 29 falls within the range of the gap region 2a. Due to this, it is possible to reduce decreases in the power generation efficiency.

### (Fifth Embodiment)

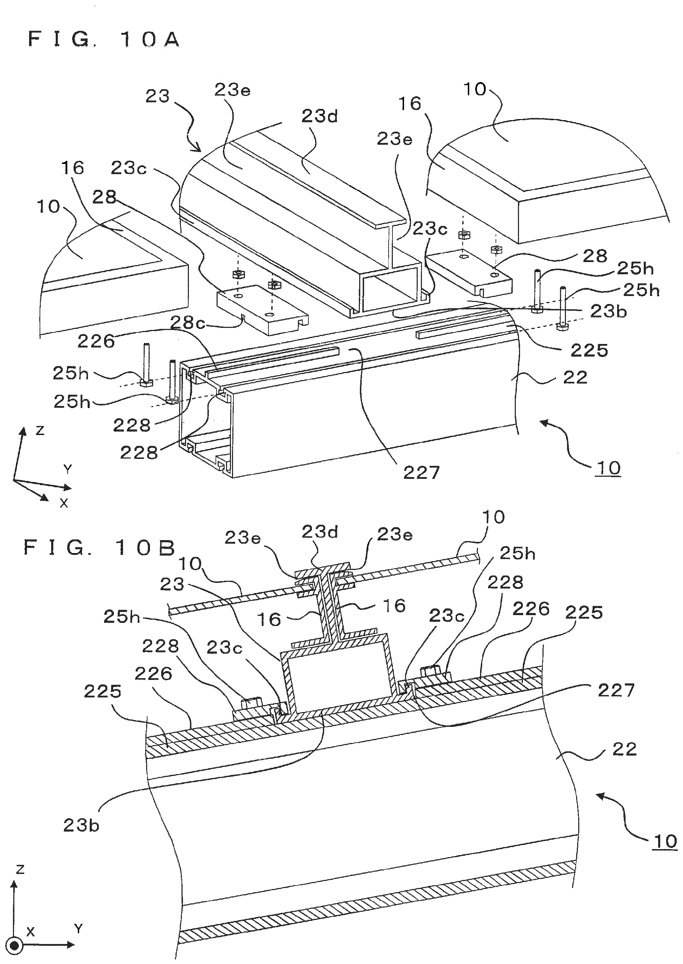

In the present embodiment, as illustrated in FIGS. 10A and 10B, the traverse rail member 23 is disposed on the holding member 22 and the holding member 22 has a first flange portion 226 on the top surface 225 thereof. In addition, in the present embodiment, there is a first notched portion 227 in the part of the first flange portion 226 where the traverse rail member 23 is disposed.

As illustrated in FIGS. 10A and 10B, the long traverse rail member 23 is disposed on the long holding member 22 such that the longitudinal directions thereof intersect with each other. At this time, a bottom portion 23b of the traverse rail member 23 is opposite to the top surface of the holding member 22. The top surface 225 of the holding member 22 has the first flange portion 226 extending along the longitudinal direction thereof. In addition, the first flange portion 226 is provided with the first notched portion 227 having a width able to engage with the bottom portion 23b of the traverse rail member 23. In addition, the top surface 225 of the holding member 22 has a plurality of fourth recess portion 228 along the longitudinal direction thereof into which it is possible to insert the bolt heads of eighth fastening members 25h.

The traverse rail member 23 has hook portions 23c provided on both sides of the bottom portion 23b in the lateral direction. Then, the traverse rail member 23 is fixed on the holding member 22 by the eighth fastening members 25h through joining members 28 engaging with the hook portions 23c. In addition, the traverse rail member 23 has opening portions 23e opened on both sides in the lateral direction on an upper portion 23d thereof. The size of the opening of the opening portions 23e in the height direction is substantially the same as the height of the frame 16 of the solar cell modules 10. Due to this, it is possible to fix the solar cell modules 10 in the opening portions 23e in the traverse rail member 23. Here, notched portions 28c on the bottom side of the joining members 28 are recesses for avoiding the first flange portion 226.

By the solar cell device X having the first notched portion 227 in the holding member 22, it is possible to mount the traverse rail member 23 on the inclined holding member 22 during construction and to fit the bottom portion 23b of the traverse rail member 23 in the first notched portion 227 of the holding member 22. Due to this, it is possible to align the positions of the traverse rail members 23. Therefore, the attachment of the traverse rail member 23 to the holding member 22 during construction is easy. As a result, it is possible to reduce worker mistakes in the construction and to shorten the work time. In addition, it is possible for the first notched portion 227 to support the traverse rail members 23 so as to not slip out from a predetermined position on the holding members 22 in a state before the traverse rail members 23 are fixed with the joining members 28. Due to this, it is possible to facilitate the work of fastening the eighth fastening members 25h for the workers.

### (Sixth Embodiment)

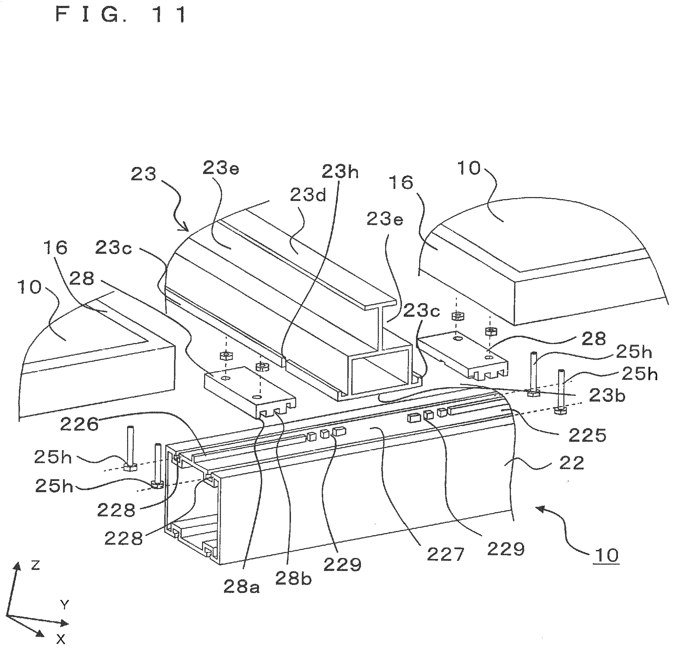

In the present embodiment, as illustrated in FIG. 11, the traverse rail member 23 has an insertion portion 23h engaging with the first flange portion 226 in the bottom portion 23b.

The insertion portion 23h of the bottom portion 23b of the traverse rail member 23 is open in a direction intersecting with the longitudinal direction. It is sufficient when the opening width of the insertion portion 23h is a width able to engage with the first flange portion 226. In the present embodiment, as an example, the insertion portion 23h is provided in a portion of the hook portion 23c.

In the present embodiment, when the traverse rail members 23 are mounted on the holding members 22, it is possible to dispose the traverse rail members 23 on the holding members 22 after carrying out alignment in the X direction by fitting the first flange portions 226 in the insertion portions 23h. Due to this, the attachment of the traverse rail members 23 to the holding members 22 during construction is easy. As a result, it is possible to reduce worker mistakes in the construction and to shorten the work time.

In addition, the joining members 28 may have an engaging portion 28b formed of a plurality of concave shaped sections in a lower portion 28a opposite to the top surface 225 of the holding member 22. Then, the holding member 22 has a gap portion 229 engaging with the engaging portion 28b in the first flange portion 226.

By the solar cell device X having the gap portion 229 and the engaging portion 28b, it is possible to firmly fix the joining members 28 to the holding member 22. As a result, in the present embodiment, it is possible to reduce position shifting of one of the traverse rail members 23 and the joining members 28 caused by loads due to snow load or the like.

### (Seventh Embodiment)

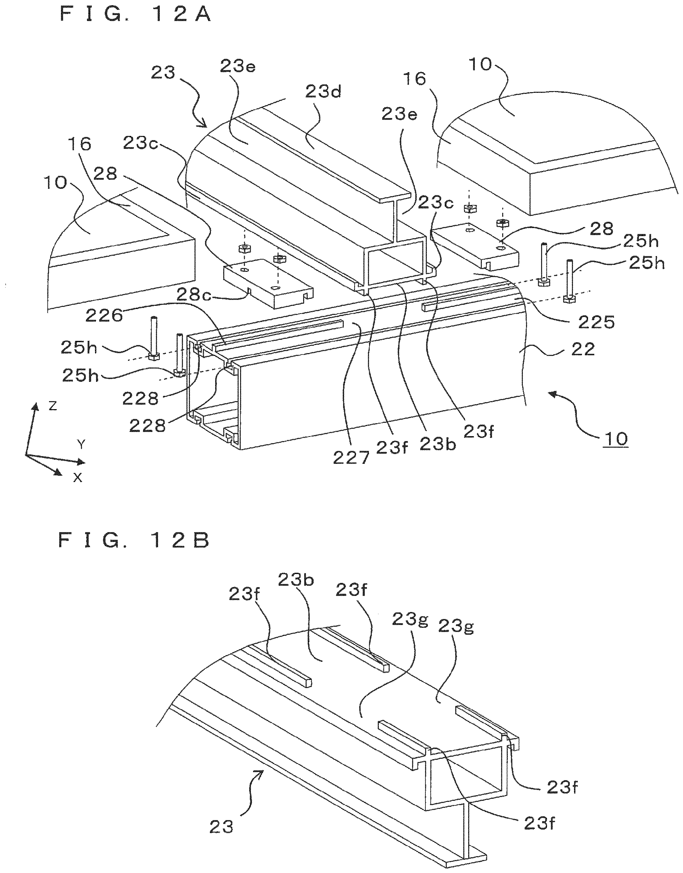

In the present embodiment, as illustrated in FIGS. 12A and 12B, the traverse rail member 23 has second flange portions 23f in the bottom portion 23b of the lower surface thereof. In addition, in the present embodiment, there are second notched portions 23g in parts of the second flange portions 23f in which the holding members 22 are positioned.

Specifically, the traverse rail member 23 is provided with the second flange portions 23f in the bottom portion 23b so as to extend in the longitudinal direction thereof. The second notched portions 23g with substantially the same width as the width of the top surface 225 of the holding member 22 in the lateral direction are provided in the second flange portions 23f.

In the present embodiment, when mounting the traverse rail members 23 on the holding members 22 during construction, it is possible to easily align the positions of the traverse rail members 23 on the holding member 22 in the X direction by engaging the second notched portions 23g with the holding members 22. Due to this, the attachment of the traverse rail members 23 to the holding members 22 during construction is easy. As a result, it is possible to reduce worker mistakes in the construction and to shorten the work time.

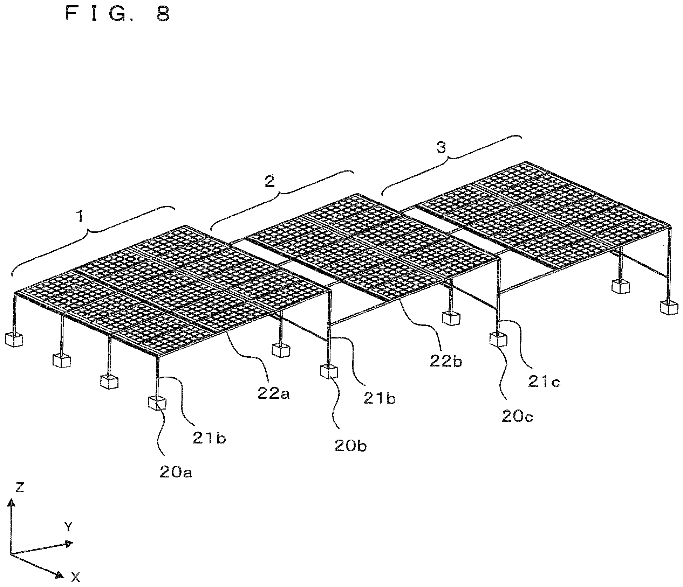

In addition, the present invention is not limited to the embodiments described above. For example, instead of being formed of only the first solar cell array 1 and the second solar cell array 2, for example, the solar cell device may be structured to also have a third solar cell array 3 fixed using the third support members 21c of the second solar cell array 2 as illustrated in FIG. 8. The invention is defined and limited by the appended claims.

### REFERENCE NUMBER

X Solar cell device
P Ground
1 First solar cell array
1a Uppermost section
2 Second solar cell array
2a Gap region
3 Third solar cell array
10 Solar cell module
11 Translucent substrate
12 Solar cell element
13 Sealing material
14 Rear surface protecting member
15 Solar cell panel
15a First surface
15b Second surface
16 Frame
16a Bottom surface
20 Base
20a First base
20b Second base
20c Third base
21 Support member
211 Top portion
211a First top portion
211 b Second top portion
211c Third top portion
212 Side portion
213a Flange portion
213b Protruding portion
214 Notched portion
215 First recess portion
21a First support member
21b Second support member
21c Third support member
22 Holding member
221 Lower surface
222 Second recess portion
223 Inner wall surface
224 Third recess portion
225 Top surface
226 First flange portion
227 First notched portion
228 Fourth recess portion
229 Gap portion
22a First holding member
22b Second holding member
22c Third holding member
23 Traverse rail member
23a Protruding portion
23b Bottom portion
23c Hook portion
23d Upper portion
23e Opening portion
23f Second flange portion
23g Second notched portion
23h Insertion portion
24 Attachment portion
24a First attachment portion
24b Second attachment portion
24c Round hole
25 Fastening member
25a - 25h First to eighth fastening member
26 Connecting member
27 First reinforcing member
27a Rail member
27b Fixing member
27b1 First surface
27b2 Second surface
28 Joining member
28a Lower section
28b Engaging portion
28c Recess portion
29 Second reinforcing member
29a Rail member
29b Fixing member

## Claims

1. A solar cell device (X) comprising:
a first solar cell array (1) and a second solar cell array (2) disposed side by side in one direction and each including a plurality of solar cell modules (10) disposed side by side along a direction inclined with respect to an installation surface (P) and a holding member (22) holding an outer circumference of each of the solar cell modules (10); and
a support member (21) disposed between the first solar cell array (1) and the installation surface (P) and extending from the first solar cell array (1) to the installation surface (P),
wherein a part of the holding member (22) in the first solar cell array (1) positioned on an upper side in the inclined direction is fixed to a top portion of the support member (21),
wherein a part of the holding member (22) in the second solar cell array (2) positioned on a lower side in the inclined direction is fixed to a side portion (212) of the support member (21),
the second solar cell array (2) is fixed to the side portion (212) of the support member (21) via an attachment member (24),
the attachment member (24) has a first attachment portion (24a) attached to the side portion (212) of the support member (21) and a second attachment portion (24b) joined with the first attachment portion (24a) and supporting the holding member (22) of the second solar cell array (2) from a side of the installation surface (P) side,
the support member (21) includes a flange portion (213a) protruding from the side portion (212) along a longitudinal direction of the support member (21), and
the flange portion (213a) has a notched portion (214) engaging with the first attachment portion (24a),
**characterized in that**
the longitudinal direction of the support member (21) is a direction orthogonal or substantially orthogonal to the installation surface (P).

2. The solar cell device (X) according to claim 1, wherein
the support member (21) includes flange portions (213a) protruding from the side portion (212) along the longitudinal direction, and
the flange portions (213a) include notched portions (214) engaging with the first attachment portion (24a).

3. The solar cell device (X) according to claim 1, wherein the second solar cell array (2) has a gap region (2a), in which the plurality of solar cell modules (10) is not installed, between the support member (21) and the plurality of solar cell modules (10) positioned on the lower side in the inclined direction.

4. The solar cell device (X) according to claim 1 or claim 3, further comprising:
a first reinforcing member (27) fixed to the holding member (22) and the support member (21) so as to span from a lower surface of the holding member (22), which is positioned at the lower side in the inclined direction in the second solar cell array (2), to the support member (21),
wherein the first reinforcing member (27) is fixed to the side portion at a position closer to the installation surface (P) side than a position at which the holding member (22) of the second solar cell array (2) is fixed in the side portion (212) of the support member (21).

5. The solar cell device (X) according to any one of claims 1 to 4, further comprising:
a second reinforcing member (29) fixed to the holding member (22) and the support member (21) so as to span from a top surface of the holding member (22), which is positioned at the lower side in the inclined direction in the second solar cell array (2), to the support member (21),
wherein the second reinforcing member (29) is fixed to the side portion (212) at a position closer to the top portion side than a position at which the holding member (22) of the second solar cell array (2) is fixed in the side portion (212) of the support member (21).

6. The solar cell device (X) according to any one of claims 1 to 5, further comprising:
a traverse rail member (23) disposed on the top surface of the holding member (22) to intersect with the holding member (22);
wherein the holding member (22) comprising
a first flange portion (226) provided on the top surface (225) and
a first notched portion (227) in a part of the first flange portion (226) where the traverse rail member (23) is disposed.

7. The solar cell device (X) according to claim 6, wherein the traverse rail member (23) has an insertion portion (23h) to be inserted into the first flange portion (226).

8. The solar cell device (X) according to claim 6 or claim 7, wherein the traverse rail member (23) has a second flange portion (23f) provided on the lower surface and a second notched portion (23g) in a part of the second flange portion (23f) where the holding member (22) is positioned.

## Patentansprüche

1. Solarzellenvorrichtung (X), aufweisend:
eine erste Solarzellenanordnung (1) und eine zweite Solarzellenanordnung (2), die nebeneinander in einer Richtung angeordnet sind und jeweils eine Mehrzahl von Solarzellenmodulen (10), die nebeneinander entlang einer Richtung angeordnet sind, die in Bezug auf eine Installationsfläche (P) geneigt ist, und ein Halteelement (22), das einen Außenumfang von jedem der Solarzellenmodule (10) hält, aufweisen, und
ein Stützelement (21), das zwischen der ersten Solarzellenanordnung (1) und der Installationsfläche (P) angeordnet ist und sich von der ersten Solarzellenanordnung (1) zu der Installationsfläche (P) erstreckt,
wobei ein Teil des Halteelements (22) in der ersten Solarzellenanordnung (1), der auf einer oberen Seite in der Neigungsrichtung positioniert ist, an einem oberen Abschnitt des Stützelements (21) befestigt ist,
wobei ein Teil des Halteelements (22) in der zweiten Solarzellenanordnung (2), der auf einer unteren Seite in der Neigungsrichtung positioniert ist, an einem Seitenabschnitt (212) des Stützelements (21) befestigt ist,
die zweite Solarzellenanordnung (2) über ein Befestigungselement (24) an dem Seitenabschnitt (212) des Stützelements (21) befestigt ist,
das Befestigungselement (24) einen ersten Befestigungsabschnitt (24a), der an dem Seitenabschnitt (212) des Stützelements (21) befestigt ist, und einen zweiten Befestigungsabschnitt (24b) aufweist, der mit dem ersten Befestigungsabschnitt (24a) verbunden ist und das Halteelement (22) der zweiten Solarzellenanordnung (2) von einer Seite der Installationsfläche- (P) -Seite aus abstützt,
das Stützelement (21) einen Flanschabschnitt (213a) aufweist, der von dem Seitenabschnitt (212) aus entlang einer Längsrichtung des Stützelements (21) hervorsteht, und
der Flanschabschnitt (213a) einen Aussparungsabschnitt (214) aufweist, der mit dem ersten Befestigungsabschnitt (24a) in Eingriff ist,
**dadurch gekennzeichnet, dass**
die Längsrichtung des Stützelements (21) eine Richtung orthogonal oder im Wesentlichen orthogonal zu der Installationsfläche (P) ist.

2. Solarzellenvorrichtung (X) gemäß Anspruch 1, wobei
das Stützelement (21) Flanschabschnitte (213a) aufweist, die von dem Seitenabschnitt (212) aus entlang der Längsrichtung hervorstehen, und
die Flanschabschnitte (213a) Aussparungsabschnitte (214) aufweisen, die mit dem ersten Befestigungsabschnitt (24a) in Eingriff sind.

3. Solarzellenvorrichtung (X) gemäß Anspruch 1, wobei die zweite Solarzellenanordnung (2) einen Abstandsbereich (2a), in dem die Mehrzahl von Solarzellenmodulen (10) nicht installiert ist, zwischen dem Stützelement (21) und der Mehrzahl von Solarzellenmodulen (10) aufweist, positioniert auf der unteren Seite in der Neigungsrichtung.

4. Solarzellenvorrichtung (X) gemäß Anspruch 1 oder Anspruch 3, ferner aufweisend:
ein erstes Verstärkungselement (27), das an dem Halteelement (22) und dem Stützelement (21) befestigt ist, um sich von einer unteren Fläche des Halteelements (22), die auf der unteren Seite in der Neigungsrichtung in der zweiten Solarzellenanordnung (2) positioniert ist, zum Stützelement (21) zu erstrecken,
wobei das erste Verstärkungselement (27) an dem Seitenabschnitt an einer Position befestigt ist, die näher an der Installationsfläche- (P) -Seite liegt als eine Position, an der das Halteelement (22) der zweiten Solarzellenanordnung (2) im Seitenabschnitt (212) des Stützelements (21) befestigt ist.

5. Solarzellenvorrichtung (X) gemäß irgendeinem der Ansprüche 1 bis 4, ferner aufweisend:
ein zweites Verstärkungselement (29), das an dem Halteelement (22) und dem Stützelement (21) befestigt ist, um sich von einer oberen Fläche des Halteelements (22), die auf der unteren Seite in der Neigungsrichtung in der zweiten Solarzellenanordnung (2) positioniert ist, zum Stützelement (21) zu erstrecken,
wobei das zweite Verstärkungselement (29) an dem Seitenabschnitt (212) an einer Position befestigt ist, die näher bei der oberer-Abschnitt-Seite liegt als eine Position, an der das Halteelement (22) der zweiten Solarzellenanordnung (2) in dem Seitenabschnitt (212) des Stützelements (21) befestigt ist.

6. Solarzellenvorrichtung (X) gemäß irgendeinem der Ansprüche 1 bis 5, ferner aufweisend:
ein Querschienenelement (23), das auf oberen Fläche des Halteelements (22) angeordnet ist, um sich mit dem Halteelement (22) zu schneiden,
wobei das Halteelement (22) aufweist:
einen ersten Flanschabschnitt (226), der auf der oberen Fläche (225) vorgesehen ist, und
einen ersten Aussparungsabschnitt (227) in einem Teil des ersten Flanschabschnitts (226), wo das Querschienenelement (23) angeordnet ist.

7. Solarzellenvorrichtung (X) gemäß Anspruch 6, wobei das Querschienenelement (23) einen Einsetzabschnitt (23h) aufweist, um in den ersten Flanschabschnitt (226) eingesetzt zu sein.

8. Solarzellenvorrichtung (X) gemäß Anspruch 6 oder Anspruch 7, wobei das Querschienenelement (23) einen zweiten Flanschabschnitt (23f), der auf der unteren Fläche vorgesehen ist, und einen zweiten Aussparungsabschnitt (23g) in einem Teil des zweiten Flanschabschnitts (23f) aufweist, wo das Halteelement (22) positioniert ist.

## Revendications

1. Un dispositif de cellules solaires (X), comprenant :
un premier réseau de cellules solaires (1) et un deuxième réseau de cellules solaires (2) disposés côte à côte dans une direction et comprenant chacun une pluralité de modules de cellules solaires (10) disposés côte à côte le long d'une direction inclinée par rapport à une surface d'installation (P) et un élément de maintien (22) maintenant une circonférence extérieure de chacun des modules de cellules solaires (10) ; et
un élément de support (21) disposé entre le premier réseau de cellules solaires (1) et la surface d'installation (P) et s'étendant du premier réseau de cellules solaires (1) à la surface d'installation (P),
dans lequel une partie de l'élément de maintien (22) du premier réseau de cellules solaires (1) positionné sur un côté supérieur dans la direction inclinée est fixée à une partie supérieure de l'élément de support (21),
dans lequel une partie de l'élément de maintien (22) du deuxième réseau de cellules solaires (2) positionné sur un côté inférieur dans la direction inclinée est fixée à une partie latérale (212) de l'élément de support (21),
le deuxième réseau de cellules solaires (2) est fixé à la partie latérale (212) de l'élément de support (21) par un élément de fixation (24),
l'élément de fixation (24) comporte une première partie de fixation (24a) fixée à la partie latérale (212) de l'élément de support (21) et une deuxième partie de fixation (24b) reliée à la première partie de fixation (24a) et supportant l'élément de maintien (22) du deuxième réseau de cellules solaires (2) depuis un côté du côté de surface d'installation (P),
l'élément de support (21) comprend une partie de bride (213a) qui fait saillie de la partie latérale (212) le long d'une direction longitudinale de l'élément de support (21), et
la partie de bride (213a) comporte une partie encochée (214) s'engageant avec la première partie de fixation (24a),
**caractérisé en ce que**
la direction longitudinale de l'élément de support (21) est une direction orthogonale ou sensiblement orthogonale à la surface d'installation (P).

2. Dispositif de cellules solaires (X) selon la revendication 1, dans lequel
l'élément de support (21) comprend des parties de bride (213a) faisant saillie de la partie latérale (212) selon la direction longitudinale, et
les parties de bride (213a) comprennent des parties encochées (214) s'engageant avec la première partie de fixation (24a).

3. Dispositif de cellules solaires (X) selon la revendication 1, dans lequel le deuxième réseau de cellules solaires (2) présente une zone de fente (2a), dans laquelle la pluralité de modules de cellules solaires (10) n'est pas installée, entre l'élément de support (21) et la pluralité de modules de cellules solaires (10), dans une position sur le côté inférieur dans la direction inclinée.

4. Dispositif de cellules solaires (X) selon la revendication 1 ou la revendication 3, comprenant en outre :
un premier élément de renforcement (27) fixé à l'élément de maintien (22) et à l'élément de support (21) de manière à s'étendre d'une surface inférieure de l'élément de maintien (22), qui est positionnée sur le côté inférieur dans la direction inclinée dans le deuxième réseau de cellules solaires (2), à l'élément de support (21),
dans lequel le premier élément de renforcement (27) est fixé à la partie latérale à une position plus proche du côté de surface d'installation (P) qu'une position à laquelle l'élément de maintien (22) du deuxième réseau de cellules solaires (2) est fixé dans la partie latérale (212) de l'élément de support (21).

5. Dispositif de cellules solaires (X) selon l'une quelconque des revendications 1 à 4, comprenant en outre :
un deuxième élément de renforcement (29) fixé à l'élément de maintien (22) et à l'élément de support (21) de manière à s'étendre depuis une surface supérieure de l'élément de maintien (22), qui est positionnée sur le côté inférieur dans la direction inclinée dans le deuxième réseau de cellules solaires (2), jusqu'à l'élément de support (21),
dans lequel le deuxième élément de renforcement (29) est fixé à la partie latérale (212) à une position plus proche du côté de partie supérieure qu'une position à laquelle l'élément de maintien (22) du deuxième réseau de cellules solaires (2) est fixé dans la partie latérale (212) de l'élément de support (21).

6. Dispositif de cellules solaires (X) selon l'une quelconque des revendications 1 à 5, comprenant en outre :
un élément de rail transversal (23) disposé sur la surface supérieure de l'élément de support (22) pour croiser l'élément de support (22) ;
dans lequel l'élément de maintien (22) comprend
une première partie de bride (226) prévue sur la surface supérieure (225) et
une première partie encochée (227) dans une partie de la première partie de bride (226) où est disposé l'élément de rail transversal (23).

7. Dispositif de cellules solaires (X) selon la revendication 6, dans lequel l'élément de rail transversal (23) présente une partie d'insertion (23h) à insérer dans la première partie de bride (226).

8. Dispositif de cellules solaires (X) selon la revendication 6 ou la revendication 7, dans lequel l'élément de rail transversal (23) présente une deuxième partie de bride (23f) prévue sur la surface inférieure et une deuxième partie encochée (23g) dans une partie de la deuxième partie de bride (23f) où l'élément de maintien (22) est positionné.
